**Europäisches Patentamt**

**European Patent Office**

**Office européen des brevets**

(19)

(11) Veröffentlichungsnummer: **0 150 275**
**B1**

(12) **EUROPÄISCHE PATENTSCHRIFT**

(45) Veröffentlichungstag der Patentschrift: **05.09.90**

(51) Int. Cl.⁵: **G 06 F 11/10**

(21) Anmeldenummer: **84112725.1**

(22) Anmeldetag: **22.10.84**

(54) Schaltungsanordnung zur Prüfbiterzeugung.

(30) Priorität: **25.10.83 DE 3338742**

(43) Veröffentlichungstag der Anmeldung:
**07.08.85 Patentblatt 85/32**

(45) Bekanntmachung des Hinweises auf die
Patenterteilung:
**05.09.90 Patentblatt 90/36**

(84) Benannte Vertragsstaaten:
**AT BE CH DE FR GB IT LI NL SE**

(56) Entgegenhaltungen:
**EP-A-0 019 774**
**DE-A-2 252 035**
**US-A-3 758 760**
**US-A-4 084 253**

(73) Patentinhaber: **Siemens Aktiengesellschaft**
**Wittelsbacherplatz 2**
**D-8000 München 2 (DE)**

(72) Erfinder: **Nussbächer, Hans Klaus, Dipl.-Ing.**
**Strassbergerstrasse 12**
**D-8000 München 40 (DE)**

## Beschreibung

Die Erfindung betrifft eine Schaltungsanordnung zur Prüfbiterzeugung bei der Verknüpfung zweier Operanden.

Die ständig wachsenden Leistungsanforderungen an Datenverarbeitungsanlagen und ihre Zentralprozessoren machen immer raschere Verknüpfungseinheiten, wie beispielsweise Addierer oder Arithmetik-Logik-Einheiten (ALU), als deren Kernstücke erforderlich. Gleichzeitig besteht neben der raschen Ergebnisbereitstellung die dringende Notwendigkeit, deren Absicherung ebenfalls laufzeitgünstig zu realisieren. Dazu werden beispielsweise Bitfolgen zur Sicherung gegen Übertragungsfehler und ähnliches, wort- oder blockweise mit einem oder mehreren zusätzlichen Prüfbits versehen. Um zur Weiterverarbeitung ein vollständiges Ergebnis der Rechenoperation zu erhalten, muß deshalb im Anschluß an den eigentlichen Rechenvorgang die Generierung eines bzw. mehrerer Prüfbits erfolgen. Solche Ablaufvorgänge können die Zykluszeiten der Prozessoren direkt beeinflussen.

Wenn die Bereitstellung der Prüfbits auf bekannte Weise seriell nach der Erzeugung des Verknüpfungsergebnisses stattfindet, so kann zwar ein Prozessorzyklus aus der Durchlaufzeit der eigentlichen Rechendaten bestehen, wenn die Voraussetzung dafür gegeben ist, daß die Berechnung der Prüfbits zeitlich überlappt in den nächsten Zyklus hineinreichen kann. Ist eine Überlappung jedoch nicht zulässig, so geht die Prüfbitgenerierung zusätzlich voll in die Zykluszeit ein.

Der Erfindung lag daher die Aufgabe zugrunde, ein Laufzeitoptimum für die Bereitstellung der Prüfbits zu erhalten, um die Zykluszeit möglichst kurz zu halten.

Diese Aufgabe wird durch die im Anspruch 1 genannten Merkmale gelöst.

Die Prüfbiterzeugung kann also gleichzeitig mit der eigentlichen Rechenoperation erfolgen, wobei entsprechend den beiden "bedingten" Rechenergebnissen zwei alternative, bedingte Prüfbit-Zwischenergebnisse bestimmt werden. Das eine Zwischenergebnis wird unter der Annahme ermittelt, daß der Eingangsübertrag den Wert log. 1 hat. Die Berechnung des anderen Zwischenergebnisses erfolgt unter der Annahme, daß der Eingangsübertrag eine log. Null aufweist. Sobald der gültige Ergebnisübertrag in einer Entscheidungslogik, beispielsweise einer sog. carrylook-ahead — oder einer carry-decision-Übertragerzeugung, feststeht, werden die zugeordneten, bereitstehenden Prüfbits ausgewählt. Zur gleichen Zeit wird in analoger Weise aus den vorbereiteten Zwischenergebnissen über weitere Auswahlschalter das Endergebnis der Rechenoperation erzielt. Der wesentliche Vorteil der Erfindung besteht in der laufzeitgünstigen Bereitstellung der Prüfbits, die dadurch entsteht, daß die Erzeugung der alternativen Prüfbits schon bei geringer Verarbeitungsbreite äußerst rasch erfolgt, beispielsweise über EXOR-Gatter. Die Generierung der Prüfbits erfolgt innerhalb der Laufzeit, die zur Berechnung des Verknüpfungsergebnisses, also beispielsweise bei der Summen- oder Differenzbildung, auftreten.

Die Art der die Prüfbits bereitstellenden Generierungseinrichtung kann dabei beliebig sein. Besonders vorteilhalt ist, daß die einfachste Schaltungsanordnung ausreichend ist, weil der Generierungsvorgang "verdeckt", d.h. parallel zur Summen- und Übertragsbildung abläuft, die in der Regel eine nicht unerhebliche Laufzeit benötigt. Ferner kann die Verarbeitungsbreite der Verknüpfungseinrichtung, der Prüfbitgenerierung usw. beliebig sein. Da eine Gleichartigkeit der verwendeten Prüfbiterzeugungschaltungen zwar möglich, aber nicht notwendig ist, ist die Voraussetzung für eine einfache Schaltungsentwicklung gegeben. Schließlich zeichnet sich die Erfindung durch Einfachheit und Übersichtlichkeit der Gesamtschaltungsanordnung aus.

Eine Weiterbildung der Erfindung ergibt sich aus dem Unteranspruch.

Im folgenden wird die Erfindung anhand eines Ausführungsbeispieles weiter beschrieben.

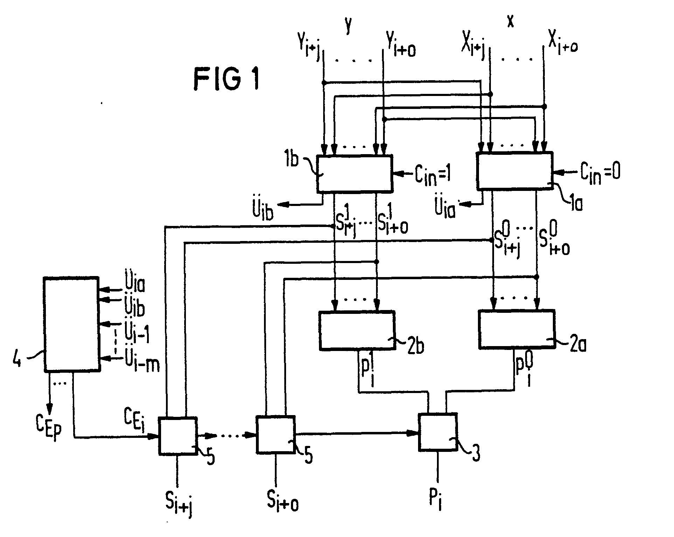

Die Fig. 1 bis 3 zeigen jeweils ein Beispiel einer Schaltungsanordnung zur Prüfbiterzeugung.

Wie Fig. 1 zeigt, sind zwei binärkodierte Operanden X, Y über Bitleitungen $X_{i+0}$ bis $X_{i+j}$ bzw. $Y_{i+0}$ bis $Y_{i+j}$ zwei parallelen Rechenwerken 1 a und 1 b mit komplementären Eingangsüberträgen $C_{In} = 0$, bzw. $C_{In} = 1$ zugeführt. Ihre Summenausgänge liegen jeweils an einem Prüfbitgenerator 2 a bzw. 2 b, deren Ausgänge mit einem ersten Auswahlschalter 3 verbunden sind.

Ferner sind die Summenausgänge der Rechenwerke 1 a und 1 b so mit zweiten Auswahlschaltern 5 verbunden, daß jeweils Summenausgänge gleicher Wertigkeit an einem der zweiten Auswahlschalter 5 liegen. Die Übertragausgänge der beiden Rechenwerke 1 a und 1 b sind einer Entscheidungslogik 4 zugeführt.

Als Folge der komplementären Eingangsüberträge $C_{In} = 0$ und $C_{In} = 1$ werden in den beiden Rechenwerken 1 a und 1 b zwei "bedingte" alternative Rechenergebnisse ermittelt, die mit $S_{i+0}^{0}$ bis $S_{i+j}^{0}$ bzw. $S_{i+0}^{1}$ bis $S_{i+j}^{1}$ bezeichnet sind. Ferner wird in jedem Rechenwerk 1 a und 1 b ein "bedingter" alternativer Übertrag ermittelt, welcher mit $Ü_{Ia}$ bzw. $Ü_{Ib}$ bezeichnet ist. Die unteren Indices i, j geben dabei die Wertigkeit der entsprechenden Bitstelle an. Aus den oberen Indices 0,1 ist abzulesen, ob unter der Bedingung eines Übertrags des log. Wertes 0 bzw. 1 gerechnet wurde.

Das tatsächliche Endergebnis der Rechenoperation kann aus den beiden alternativen Rechenergebnissen jedoch erst dann ermittelt werden, wenn der tatsächliche, für die Rechenoperation relevante Ergebnisübertrag $C_{Ei}$ bekannt ist. Dieser wird in der Entscheidungslogik 4 aus den alternativen Überträgen $Ü_{I-1}$ bis $Ü_{I-m}$ ermittelt, welche bei der Verknüpfung von niederwertigeren Operanden (nicht dargestellt) erzeugt wird. In gleicher Weise wird ein Ergebnisübertrag $C_{Ep}$ aus den beiden Überträgen $Ü_{Ia}$ und $Ü_{Ib}$ zur Ermittlung eines Rechenergebnisses von höherwertigen Operanden verwendet. Mit diesen Ergebnisüberträgen $C_{Ei}$ bzw. $C_{Ep}$ sind die Steuereingänge der jeweils zugeordneten Auswahlschalter 3 bzw. 5 beaufschlagt.

Zeitlich parallel mit der Ermittlung des Ergebnisübertrages $C_{Ei}$ wird in den beiden Prüfbitgeneratoren 2 a und 2 b jeweils ein Prüfbit $P_i^0$ bzw. $P_i^1$ ermittelt. Entsprechend den bedingten, alternativen Rechenergebnissen, aus denen sie ermittelt sind, sind auf diese Weise zwei bedingte alternative Prüfbits als Zwischenergebnisse bereitgestellt. Das Ergebnisprüfbit $P_i$ ist am Ausgang des Auswahlschalters 3 abgreifbar, sobald der Ergebnisübertrag $C_{Ei}$ zur Verfügung steht. Ferner ist dann das Rechenendergebnis $S_{i+0}$ bis $S_{i+j}$ an den Ausgängen der zweiten Auswahlschalter 5 abgreifbar.

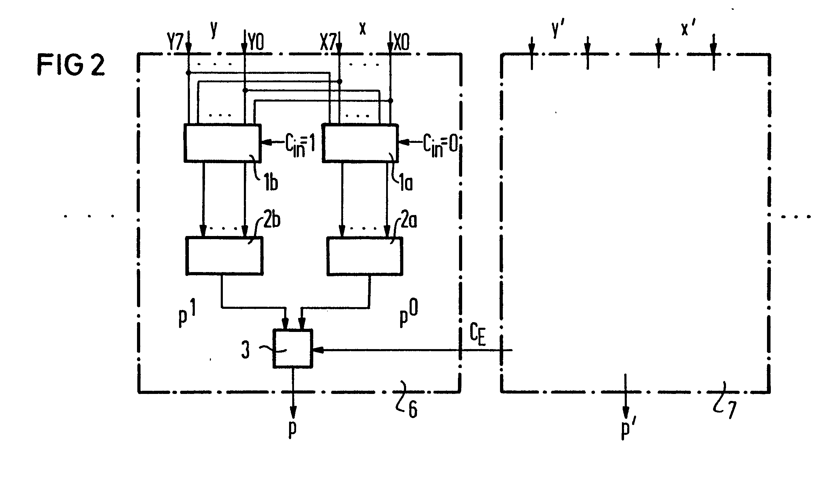

In Fig. 2 bestehen die beiden Operanden X, Y beispielhaft aus jeweils 8 Bits, die an den Bitleitungen X 0 bis X 7 bzw. Y 0 bis Y 7 abgreifbar sind. Die Schaltungsanordnung 6 zur Prüfbiterzeugung besteht wie in Fig. 1 aus zwei parallelen Rechenwerken 1 a und 1 b, welche mit komplementären Eingangsüberträgen $C_{in} = 0$ bzw. $C_{in} = 1$ beaufschlagt sind. Die Ausgänge der Rechenwerke 1 a und 1 b liegen an jeweils einem Prüfbitgenerator 2 a und 2 b. Diese liegen ausgangsseitig gemeinsam an einem Auswahlschalter 3.

Das Verknüpfungsergebnis der beiden Operanden X, Y ist im wiedergegebenen Beispiel von einem Übertrag abhängig, der von der Verknüpfung zweier niederwertigerer Operanden X', Y' in einer Recheneinheit 7 ermittelt wird. Das ist beispielsweise der Fall, wenn Datenwörter byte- oder digitweise miteinander verknüpft werden.

Es findet nun parallel zu einer Rechenoperation, in welcher ein Verknüpfungsergebnis der beiden Operatoren X, Y berechnet wird, eine Prüfbiterzeugung (Paritätsbit-Generierung) statt. Dazu werden in den beiden Rechenwerken 1 a und 1 b abhängig von den komplementären Eingangsüberträgen zwei alternative Verknüpfungsergebnisse ermittelt. Diese werden jeweils einem der als Paritätsbitgeneratoren ausgebildeten Prüfbitgeneratoren 2 a bzw. 2 b zugeführt. An deren Ausgängen sind somit entsprechend den unterschiedlichen Eingangsgrößen zwei alternative Prüfbits $P^0$, $P^1$ abgreifbar. Aus diesen als Zwischenergebnis bereitgestellten Prüfbits wird das gültige Ergebnisprüfbit P über den am Steuereingang des Auswahlschalters 3 anliegenden Eingangsübertrag $C_E$ ausgewählt, sobald dieser von der Recheneinheit 7 bereitgestellt ist. Der Eingangsübertrag $C_E$ ist in dem in Fig. 2 wiedergegebenen Beispiel der Ergebnisübertrag einer niederwertigeren gleichartigen Stufe, wie sie in einer sog. Bit-Slice-Technik eingesetzt werden.

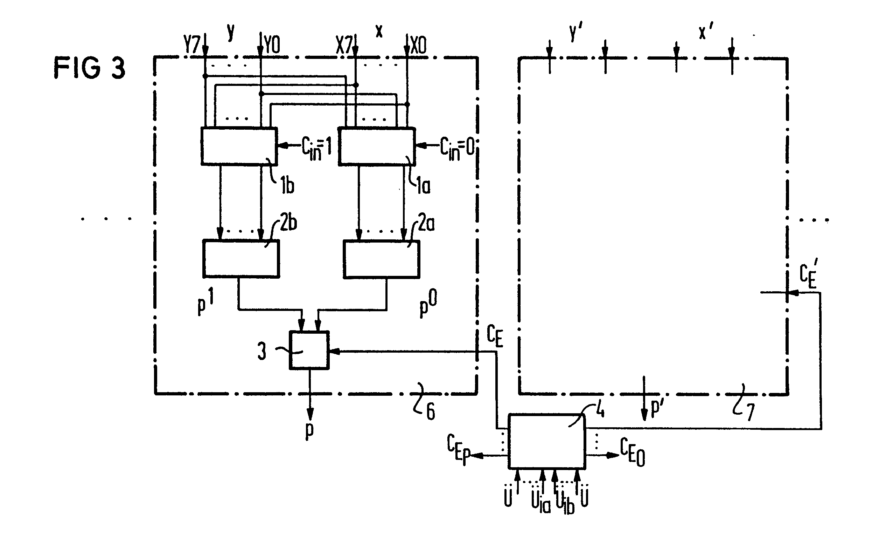

Wie das Beispiel in Fig. 3 zeigt, wird eine parallele Berechnung der Prüfbits P, P' in den wie in Fig. 2 "scheibenweise" angeordneten Schaltungsanordnungen 6, 7 dadurch erreicht, daß eine zentrale Entscheidungslogik 4 alle notwendigen Eingangüberträge $C_E$, $C'_E$ usw. erzeugt,

die den Auswahlschaltern 3 in den einzelnen Scheiben zugeführt werden.

### Patentansprüche

1. Schaltungsanordnung zur Prüfbiterzeugung bei der Verknüpfung zweier Operanden, dadurch gekennzeichnet, daß die beiden Operanden (X, Y) zwei parallelen Rechenwerken (1a, 1b) mit komplementären Eingangsüberträgen ($C_{in} = 1$, $C_{in} = 0$) zugeführt sind, deren Ausgänge jeweils an einem Prüfbitgenerator (2a, 2b) liegen, daß diese ausgangsseitig mit einem ersten Auswahlschalter (3) verbunden sind, und daß der erste Auswahlschalter (3) von einer Entscheidungslogik (4) angesteuert ist, in welcher der zur Ermittlung des Verknüpfungsergebnisses zugrunde zu legende Ergebnisübertrag ($C_{Ei}$) ermittelt wird.

2. Schaltungsanordnung nach Anspruch 1, dadurch gekennzeichnet, daß die Prüfbitgeneratoren (2a, 2b) als Paritätsbitgeneratoren ausgebildet sind.

### Revendications

1. Montage pour produire des bits de contrôle lors de la combinaison de deux opérandes, caractérisé par le fait que les deux opérandes (X, Y) sont envoyés à deux unités de calcul parallèles (1a, 1b) ayant des reports d'entrée complémentaires ($C_{in} = 1$, $C_{in} = 0$), et dont les sorties sont raccordées à des générateurs respectifs de bits de contrôle (2a, 2b), que ces derniers sont reliés, par leur sortie, à un premier commutateur de sélection (3) et que le premier commutateur de sélection (3) est commandé par une logique de décision (4), dans laquelle est déterminée le report résultant ($C_{Ei}$) qui doit être utilisé pour la détermination du résultat de la combinaison.

2. Montage suivant la revendication 1, caractérisé par le fait que les générateurs (2a, 2b) de bits de contrôle sont réalisés sous la forme de générateurs de bits de parité.

### Claims

1. Circuit arrangement for the generation of check bits during the logic operation on two operands, characterized in that the two operands (X, Y) are supplied to two parallel arithmetic units (1a, 1b) with complementary input carries ($C_{in} = 1$, $C_{in} = 0$), the outputs of which are in each case connected to a check bit generator (2a, 2b), in that these are connected at the output to a first selection switch (3), and in that the first selection switch (3) is enabled by a decision logic (4) in which the result carry ($C_{Ei}$) to be used as a basis for determining the result of the logic operation is determined.

2. Circuit arrangement according to Claim 1, characterized in that the check bit generators (2a, 2b) are designed as parity bit generators.

FIG 1

FIG 2

EP 0 150 275 B1

FIG 3

EP 0 150 275 B1

Y7  y  Y0  X7  x  X0

$C_{in}=1$    $C_{in}=0$

1b    1a

2b    2a

$p^1$    $p^0$

3    $C_E$

p    6

$C_{EP}$    4    $C_{EO}$

ü  ü$_{1a}$  ü$_{1b}$  ü

y'    x'

$C_E'$

P'    7